# EUROPÄISCHE PATENTSCHRIFT

(11) **EP 3 452 327 B1**
(45) Veröffentlichungstag und Bekanntmachung des Hinweises auf die Patenterteilung: **16.09.2020**
(21) Anmeldenummer: 17723047.1
(22) Anmeldetag: 03.05.2017
(51) Int. Cl.: B60K 37/06, B60K 35/00, B60Q 3/64, B60Q 3/14, H03K 17/96

(54) **BELEUCHTBARE SCHALTERANORDNUNG FÜR EIN KRAFTFAHRZEUG, KRAFTFAHRZEUG UND VERFAHREN ZUM HERSTELLEN EINER BELEUCHTBAREN SCHALTERANORDNUNG**
ILLUMINABLE SWITCH ARRANGEMENT FOR A MOTOR VEHICLE, MOTOR VEHICLE, AND METHOD FOR PRODUCING AN ILLUMINABLE SWITCH ARRANGEMENT
ENSEMBLE COMMUTATEUR AVEC ÉCLAIRAGE POUR UN VÉHICULE À MOTEUR, VÉHICULE À MOTEUR ET PROCÉDÉ POUR PRODUIRE UN ENSEMBLE COMMUTATEUR AVEC ÉCLAIRAGE

(30) Priorität: 06.05.2016 DE 102016005619
(43) Veröffentlichungstag der Anmeldung: 13.03.2019
(73) Patentinhaber: Audi AG, 85045 Ingolstadt (DE)
(72) Erfinder: HUPFER, Philip, 90559 Burgthann (DE)
(86) Internationale Anmeldenummer: PCT/EP2017/060556
(87) Internationale Veröffentlichungsnummer: WO 2017/191199

(56) Entgegenhaltungen:
- WO-A1-2009/136178
- DE-A1- 10 102 774
- DE-A1-102008 055 865
- DE-A1-102009 057 187

## Beschreibung

Die Erfindung geht aus von einer beleuchtbaren Schalteranordnung für ein Kraftfahrzeug, wobei die Schalteranordnung mindestens ein Schalterelement zur Erfassung einer Betätigungshandlung eines Benutzers aufweist und eine transparente Lichtleiterfolie. Diese weist eine Dicke auf, eine erste Seite und eine zweite Seite, wobei die erste Seite und die zweite Seite die Lichtleiterfolie in ihrer Dicke begrenzen und gegenüberliegend und durch die Dicke der Lichtleiterfolie beabstandet angeordnet sind. Dabei sind Abmessungen der ersten Seite und der zweiten Seite jeweils größer als die Dicke der Lichtleiterfolie. Die Lichtleiterfolie weist weiterhin eine von der ersten und zweiten Seite verschiedene Lichteintrittsseite auf, in welche Licht einkoppelbar ist, und welche die erste Seite und die zweite Seite miteinander verbindet, wobei das Schalterelement auf der zweiten Seite der Lichtleiterfolie angeordnet ist. Die Erfindung geht weiterhin aus von einem Kraftfahrzeug mit einer solchen beleuchtbaren Schalteranordnung und einem Verfahren zum Herstellen einer beleuchtbaren Schalteranordnung für ein Kraftfahrzeug.

In aktuellen Fahrzeugen kann für die Erkennung eines Schaltereignisses ein mechanischer, piezoelektrischer oder kapazitiver Taster verwendet werden. Diese sind für die Erkennung bei Nacht mit einer Symbol- oder Suchbeleuchtung ausgestattet. Häufig wird dabei für jeden Schalter eine Lichtquelle verwendet, welche meist axial zur Betätigungsrichtung angeordnet ist. Derartige Schalteranordnungen benötigen typischerweise 10 bis 15 Millimeter Bauhöhe, um die geforderte Gleichmäßigkeit der Beleuchtung zu erreichen. Aufgrund der immer angespannten Packagesituationen sind solche bauraumintensiven Schalter nur noch schwer in Fahrzeuge zu integrieren.

Durch die Verwendung von Lichtleiterfolien wird eine seitliche Anordnung von Lichtquellen ermöglicht, wodurch sich zumindest die Bauhöhe solcher Schalter etwas reduzieren lässt.

Die Verwendung einer solchen Lichtleiterfolie ist beispielsweise aus der DE 10 2008 055 865 A1 bekannt, die einen Taster zum Bedienen eines elektrischen Verbrauchers in einem Fahrzeug beschreibt. Der Taster umfasst dabei eine ortsfeste, elastisch verformbare Betätigungsfläche, die eine Sichtseite bildet, auf der eine beleuchtbare Symbolik darstellbar ist. Weiterhin umfasst der Taster eine Sensortaste, die zumindest im Bereich der Symbolik hinter der Betätigungsfläche angeordnet ist und auf eine Verformung der Betätigungsfläche schaltbar ist, einen flächigen, elastisch verformbaren Lichtleiter zur Beleuchtung der Symbolik, der zumindest im Bereich der Symbolik zwischen der Betätigungsfläche und der Sensortaste angeordnet ist, eine Lichteintrittsfläche und eine Lichtaustrittsfläche, die einander schneiden. Weiterhin umfasst der Taster eine Lichtquelle, deren emittiertes Licht über die Lichteintrittsfläche in den Lichtleiter einkoppelbar ist und aus der Lichtaustrittsfläche in Richtung der Betätigungsfläche auskoppelbar ist, wozu die Lichtaustrittsfläche im Wesentlichen parallel zur Betätigungsfläche verläuft und der Lichtleiter zur Umlenkung des Lichts im Lichtleiter ausgestaltet ist. Zur Erzeugung einer homogeneren Lichtverteilung sind weiterhin zwischen dem Lichtleiter und der Betätigungsfläche weitere Folien, insbesondere eine Diffusorfolie und mehrere Fokussierfolien angeordnet. Nachteilig an diesem Taster ist jedoch wiederum, dass aufgrund dieses vielschichtigen Aufbaus der Bauraum- und Materialbedarf relativ hoch ist und sich auch der Zusammenbau dieses Tasters relativ aufwändig gestaltet.

Weiterhin beschreibt die DE 10 2013 021 330 A1 eine beleuchtbare Anzeigevorrichtung für ein elektrisches Bedienelement, die mehrere übereinander angeordnete Symbolfolien zur Bereitstellung jeweils eines Symbols aufweist, wobei jeder Symbolfolie gleichzeitig eine jeweilige Lichtquelle zugeordnet ist, mittels welcher Licht seitlich in jeweiligen Symbolfolien einkoppelbar ist. Diese vielzähligen übereinander angeordneten Folien und Schichten erfordern jedoch wiederum viel Bauraum und insbesondere auch viele einzelne Komponenten, wie beispielsweise eine jeweilige Lichtquelle zum Anzeigen eines jeweiligen Symbols.

Die Verwendung einer Lichtleiterfolie ist auch aus der DE 10 2009 057 187 A1 bekannt. Diese offenbart ein beleuchtbares Element, insbesondere ein Betätigungsorgan für einen elektrischen Schalter mit einem beleuchtbaren Bereich, bei dem es sich um ein Symbol handelt. Weiterhin weist das Element eine Lichtquelle und einen von der Lichtquelle zum Element führenden Lichtleiter auf, sodass Licht von der Lichtquelle zum Element zur Beleuchtung des beleuchtbaren Bereichs geführt wird. Der Lichtleiter besteht dabei aus einer flexiblen Folie in der Art eines Folienlichtleiters.

Durch die Verwendung eines Folienlichtleiters und die dadurch bereitgestellte Möglichkeit der seitlichen Einkopplung des Lichts wird zwar die Bauhöhe eines solchen Schalters reduziert, dennoch besteht das Bedürfnis nach noch kompakteren Schalteranordnungen weiterhin.

Wünschenswert wäre es daher, Bedienelemente und Schalteranordnungen in möglichst kompakter Bauform, möglichst kostengünstig und mit möglichst wenigen Komponenten bereitstellen zu können. Zudem sollten solche Bedienelemente oder Schalter auch eine hohe Flexibilität hinsichtlich ihrer Gestaltungsmöglichkeiten, wie zum Beispiel ihrer Farbe, bieten, um beispielsweise eine optische Anpassung an verschieden gestaltete Fahrzeuginnenräume zu ermöglichen.

Die WO 2009/136178 A1 beschreibt eine kapazitive Erfassungsvorrichtung mit einem Lichtleiter und Lichtstreumitteln zum Beleuchten der Erfassungsvorrichtung. Die Vorrichtung umfasst einen kapazitiven Sensor auf einem Substrat und eine Lichtquelle. Zwischen dem Substrat und dem Lichtleiter kann ein Luftspalt oder eine Schicht mit verringertem Brechungsindex angeordnet sein.

Aufgabe der vorliegenden Erfindung ist es daher, eine Schalteranordnung und ein Verfahren zum Herstellen einer solchen Schalteranordnung bereitzustellen, welche eine möglichst kompakte Ausbildung und eine möglichst einfache und kostengünstige Herstellung ermöglichen.

Die Aufgabe wird gelöst durch eine beleuchtbare Schalteranordnung, ein Kraftfahrzeug mit einer solchen Schalteranordnung und ein Verfahren zum Herstellen einer beleuchtbaren Schalteranordnung gemäß den unabhängigen Ansprüchen. Vorteilhafte Ausgestaltungen der Erfindung finden sich in den abhängigen Ansprüchen.

Die erfindungsgemäße beleuchtbare Schalteranordnung für ein Kraftfahrzeug weist mindestens ein Schalterelement zur Erfassung einer Betätigungshandlung eines Benutzers und eine transparente Lichtleiterfolie auf. Diese Lichtleiterfolie weist wiederum eine Dicke auf, eine erste Seite, eine zweite Seite, wobei die erste Seite und die zweite Seite die Lichtleiterfolie in ihrer Dicke begrenzen und gegenüberliegend und durch die Dicke der Lichtleiterfolie beabstandet angeordnet sind. Dabei sind Abmessungen der ersten Seite und der zweiten Seite jeweils größer als die Dicke der Lichtleiterfolie, wobei die Lichtleiterfolie weiterhin eine von der ersten und zweiten Seite verschiedene Lichteintrittsseite aufweist, in welche Licht einkoppelbar ist, und welche die erste Seite und die zweite Seite miteinander verbindet. Darüber hinaus ist das Schalterelement auf der zweiten Seite der Lichtleiterfolie angeordnet. Weiterhin befindet sich auf der ersten Seite der Lichtleiterfolie eine Beschichtung zur Erhaltung der Lichtleitung, die insbesondere direkt auf der Lichtleiterfolie angeordnet ist. Weiterhin befindet sich eine Farbbeschichtung (direkt) auf der Beschichtung zur Erhaltung der Lichtleitung, wobei die Beschichtung zur Erhaltung der Lichtleitung und die Farbbeschichtung jeweils mindestens eine Aussparung aufweisen, sodass zumindest ein erste Lichtaustrittsbereich der ersten Seite der Lichtleiterfolie nicht von der Beschichtung zur Erhaltung der Lichtleitung und der Farbbeschichtung bedeckt ist.

Die mindestens eine Aussparung kann dabei so geformt sein, dass durch diese beleuchtbare Symbole, Zeichen, Schrift, Ornamente, oder ähnliches bereitgestellt sind. Die Farbbeschichtung ermöglicht es vorteilhafterweise, die Farbgebung der Schalteranordnung an beispielsweise ein Fahrzeuginterieur anzupassen, und kann nach Belieben beispielsweise opak, semi-opak oder transluzent ausgebildet sein. Der besonders große Vorteil der Erfindung besteht nun in der Beschichtung zur Erhaltung der Lichtleitung, die zwischen der Lichtleiterfolie und der Farbbeschichtung angeordnet ist. Würde beispielsweise die Farbbeschichtung direkt auf die Lichtleiterfolie aufgetragen werden, so würde das im Lichtleiter geführte Licht an dieser Farbbeschichtung gestreut und/oder absorbiert werden, weil die Totalreflexion innerhalb der Folie unterbrochen wird, was zu enormen Lichtverlusten führen würde und insbesondere dazu, dass die Lichtleiterfunktion der Lichtleiterfolie nicht mehr gegeben wäre. Durch die Eigenschaft der Beschichtung zur Erhaltung der Lichtleitung, die zum Beispiel als reflektierende Beschichtung oder als zusätzliche Grenzschicht mit geringerer Brechzahl ausgebildet sein kann, die dadurch die Totalreflexion innerhalb der Lichtleiterfolie erhält, bleibt jedoch vorteilhafterweise die Lichtleiterfunktion der Lichtleiterfolie erhalten und die Farbbeschichtung kann direkt auf die Beschichtung zur Erhaltung der Lichtleitung aufgebracht werden, sodass die Schalteranordnung mit besonders geringer Bauhöhe ausgebildet werden kann. Dagegen ist es im Stand der Technik erforderlich, um die Lichtleiterfunktion zu erhalten, beispielsweise Luftspalte zwischen Lichtleiterfolien und den zu beleuchtenden Schichten, auf welche Symbole aufgetragen sind, vorzusehen, was den Bauraum und den Fertigungsaufwand deutlich erhöht. Außerdem sind dann weitere Komponenten, nämlich separate Trägerschichten erforderlich, auf die die Symbolik aufgetragen werden kann. Erfindungsgemäß sind dagegen keine weiteren separaten Elemente oder Luftspalte erforderlich, und die erste Seite der Lichtleiterfolie kann insbesondere selbst die Betätigungsfläche und Sichtfläche der Schalteranordnung bereitstellen. Zudem kann durch die geringen Lichtverluste die erfindungsgemäße beleuchtbare Schalteranordnung besonders großflächig ausgebildet werden, und es können insbesondere vielzählige Schalterelemente mit korrespondierenden Symbolbereichen bereitgestellt werden, die zum Beispiel mit nur einer einzigen Lichtquelle in Kombination mit der gemeinsamen Lichtleiterfolie beleuchtet werden können. Auch die Herstellung der beschichteten Lichtleiterfolie gestaltet sich besonders einfach und ist damit auch besonders kostengünstig, da sowohl wenig Material als auch nur wenige Einzelkomponenten erforderlich sind.

Für die Beschichtung zur Erhaltung der Lichtleitung gibt es nun mehrere Möglichkeiten. Beispielsweise kann die Beschichtung zur Erhaltung der Lichtleitung als eine reflektierende Beschichtung ausgebildet sein. Dadurch kann die Lichtleitfunktion der Lichtleiterfolie im Gegensatz zu einer direkt auf die Lichtleiterfolie aufgebrachte Farbbeschichtung bereits deutlich erhöht werden. Dennoch sind bei reflektierender Beschichtung zum Teil auch sehr große Lichtverluste zu verzeichnen. Bei einer besonders vorteilhaften Ausgestaltung der Erfindung ist daher die Beschichtung zur Erhaltung der Lichtleitung als eine transparente Beschichtung ausgebildet, die einen niedrigeren bzw. kleineren Brechungsindex aufweist als die Lichtleiterfolie. Durch den geringeren Brechungsindex kann die Funktionalität der Totalreflexion von in der Lichtleiterfolie geführtem Licht an der Grenzfläche zur transparenten Beschichtung erhalten werden und zudem sind bei einer derartigen Ausbildung der Beschichtung zur Erhaltung der Lichtleitung vorteilhafterweise kaum Lichtverluste bei der Reflexion des in der Lichtleiterfolie geführten Lichts an der Grenzschicht zwischen der ersten Seite der Lichtleiterfolie und der transparenten Beschichtung zu verzeichnen. Damit lässt sich auch bei sehr großflächiger Ausbildung der Lichtleiterfolie bzw. der Schalteranordnung insgesamt eine intensive und homogene Beleuchtung bereitstellen.

Weiterhin kann die Beschichtung zur Erhaltung der Lichtleitung beispielsweise eine transparente Lackschicht darstellen, die durch Lackieren oder Bedrucken auf die Lichtleiterfolie aufgebracht werden kann. Auch kann die transparente Beschichtung beispielsweise durch eine weitere transparente Folie mit niedrigerem Brechungsindex als die Lichtleiterfolie bereitgestellt sein, die durch Extrudieren auf die erste Seite der Lichtleiterfolie aufgebracht ist. Derartige Ausbildungen erfordern kaum Bauhöhe und ermöglichen beispielsweise eine Ausbildung der Lichtleiterfolie mit Beschichtungen im Bereich von 0,5 Millimetern.
In gleicher Weise kann es auch vorgesehen sein, dass eine derartige Beschichtung zur Erhaltung der Lichtleitung auch auf die zweite Seite der Lichtleiterfolie aufgebracht wird. Diese kann dann, zum Beispiel durch Aufbringen einer oder mehrerer weiterer Beschichtungen, z.B. einer weiteren Farbbeschichtung auf diese, für vielzählige weitere Gestaltungsmöglichkeiten genutzt werden.

Bei einer weiteren vorteilhaften Ausgestaltung der Erfindung weist die Lichtleiterfolie Aktivierungsstrukturen zur Lichtauskopplung auf. Solche Aktivierungsstrukturen, die beispielsweise durch Laseraktivierung auf der Oberfläche der Lichtleiterfolie erzeugt werden können, bewirken eine Lichtstreuung des im Lichtleiter geführten Lichts an diesen aktivierten Oberflächenbereichen, wodurch der Lichtaustritt aus dem zumindest einen ersten Lichtaustrittsbereich gefördert wird. Dazu können die Aktivierungsstrukturen bei einer besonders vorteilhaften Ausgestaltung der Erfindung im ersten Lichtaustrittsbereich der ersten Seite angeordnet sein. Dies ist besonders vorteilhaft, da gerade in diesem Lichtaustrittsbereich zur Beleuchtung der durch die Aussparung bereitgestellten Symbole der Lichtaustritt des in der Lichtleiterfolie geführten Lichts ermöglicht werden soll. Zudem wird dadurch eine besonders einfache und kostengünstige Herstellung der Schalteranordnung ermöglicht, denn die Aussparungen in der Beschichtung zur Erhaltung der Lichtleitung und in der Farbbeschichtung können beispielsweise mittels Laserverfahren durch Entfernung entsprechender Bereiche der Farbbeschichtung und der Beschichtung zur Erhaltung der Lichtleitung bereitgestellt werden, wobei dadurch gleichzeitig der Lichtleiter in diesem Lichtaustrittsbereich aktiviert werden kann, das heißt die Aktivierungsstrukturen in diesem Lichtaustrittsbereich erzeugt werden können. Die Bildung der Aussparungen sowie die Aktivierung der Lichtleiterfolie können damit in einem Verfahrensschritt besonders schnell und kostengünstig bereitgestellt werden.

Auch sind alternativ andere Ausbildungen der Schalteranordnung denkbar. Beispielsweise können die Aussparungen in der Beschichtung zur Erhaltung der Lichtleitung und in der Farbbeschichtung durch eine korrespondierende Maskierung der Lichtleiterfolie auf der ersten Seite bei der Beschichtung, zum Beispiel beim Bedrucken, mit der Beschichtung zur Erhaltung der Lichtleitung und der Farbbeschichtung erzeugt werden. In diesem Fall ist es vorteilhaft, die Aktivierungsstrukturen nicht auf der ersten Seite der Lichtleiterfolie im Lichtaustrittsbereich vorzusehen, sondern auf der gegenüberliegenden zweiten Seite der Lichtleiterfolie in einem Bereich, welcher dem Lichtaustrittsbereich gegenüberliegt. Dies hat den großen Vorteil, dass keine präzise Aktivierung der Lichtleiterfolie genau entsprechend der durch den Lichtaustrittsbereich bereitgestellten Symbolik erfolgen muss, sondern die Aktivierung kann auf der zweiten Seite in einem Bereich erfolgen, der flächenmäßig größer ist als der Lichtaustrittsbereich und diesem gegenüberliegt. Die auf diesen aktivierten Bereich auftreffenden, im Lichtleiter geführten Lichtstrahlen werden dadurch ebenfalls gestreut und treten aus dem ersten Lichtaustrittsbereich der ersten Seite aus.

Bei einer weiteren vorteilhaften Ausgestaltung der Erfindung weist die Schalteranordnung zumindest eine erste Lichtquelle auf, die dazu ausgelegt ist, die Lichteintrittsseite der Lichtleiterfolie zu beleuchten. Die Hauptabstrahlrichtung der Lichtquelle ist dabei bevorzugt senkrecht zur Lichteintrittsseite, was eine maximale Lichteinkopplung und eine optimale Lichtführung im Lichtleiter ermöglicht. Auch sind weitere Optiken, lichtleitende oder lichtformende Elemente denkbar, über welche das Licht der ersten Lichtquelle in die Lichteintrittsseite eingekoppelt wird. Die Lichtquelle kann beispielsweise als eine LED ausgebildet sein, was eine besonders kompakte Ausbildung der Schalteranordnung ermöglicht. Es können jedoch auch andere Arten von Lichtquellen verwendet werden. Zudem kann die Lichtquelle eine beliebige Farbe aufweisen oder es können auch mehrere Lichtquellen unterschiedlicher Farben und/oder an unterschiedlichen Stellen, zum Beispiel an mehreren Lichteintrittsseiten der Lichtleiterfolie vorgesehen sein. Die Lichtquelle kann beispielsweise permanent leuchten, insbesondere zumindest im Betrieb des Kraftfahrzeugs, um so eine Suchbeleuchtung durch die Beleuchtung der jeweiligen Symbole der Schalterelemente oder Schalteranordnung bereitzustellen.

Bei einer weiteren vorteilhaften Ausgestaltung der Erfindung ist das Schalterelement in einem Bereich der zweiten Seite angeordnet, welche dem Lichtaustrittsbereich der ersten Seite gegenüberliegt. Eine Berührung oder Betätigung der Schalteranordnung im Bereich des korrespondierenden Symbols kann dadurch vorteilhafterweise vom Schalterelement erfasst werden. Insbesondere für den Fall, dass mehrere Schalterelemente vorgesehen sind, weisen auch die Beschichtungen jeweilige korrespondierende und entsprechende Symbole bildende Aussparungen auf, die dem betreffenden Schalterelement jeweils gegenüberliegend angeordnet sind.

Dabei ist es besonders vorteilhaft, wenn das Schalterelement als piezoelektrisches Schalterelement oder als kapazitives Schalterelement ausgebildet ist. Insbesondere können auch mehrere Schalterelemente unterschiedlichen Typs vorgesehen sein. Dadurch können vorteilhafterweise eine Touchbedienung, eine Annäherungssensorik oder auch druckabhängige Funktionsauslösungen umgesetzt werden. Gerade diese nicht rein mechanischen Schalterelemente ermöglichen dabei weiterhin einen besonders flachen Aufbau der Schalteranordnung.

Bei einer weiteren vorteilhaften Ausgestaltung der Erfindung weist die Schalteranordnung einen Träger auf, auf welchem das Schalterelement angeordnet ist, wo dass sich das Schalterelement zwischen dem Träger und der Lichtleiterfolie befindet. Auf einem solchen Träger können vorteilhafterweise auch mehrere Schalterelemente in beliebiger Weise, zum Beispiel in Zeilen und Spalten, angeordnet sein, sodass verschiedene Schaltfunktionen innerhalb derselben Trägerbaugruppe realisiert werden können. Bedingt durch die variable Anordnungsmöglichkeit der Symbole auf der Lichtleiterfolie, können damit auf besonders vorteilhafte Weise verschiedene Design und Schalteranordnungen auf besonders einfache und flexible Weise bereitgestellt werden.

Bei einer weiteren vorteilhaften Ausgestaltung der Erfindung weist die erste Seite der Lichtleiterfolie einen zweiten Lichtaustrittsbereich auf, der zumindest nicht von der Farbschicht, und insbesondere auch nicht von der Beschichtung zur Erhaltung der Lichtleitung bedeckt ist, wobei die zweite Seite der Lichtleiterfolie eine zum zweiten Lichtaustrittsbereich korrespondierenden, insbesondere dem zweiten Lichtaustrittsbereich gegenüberliegenden, zweiten Lichteintrittsbereich aufweist, wobei die Schalteranordnung eine zweite Lichtquelle aufweist, mittels welcher Licht in den zweiten Lichteintrittsbereich einkoppelbar ist, welches aus dem zweiten Lichtaustrittsbereich austritt. Durch diese Ausbildung lässt sich vorteilhafterweise zusätzlich eine Funktionsrückmeldung bereitstellen, das heißt die Lichtquelle kann beispielsweise in Abhängigkeit von einer Betätigung der Schalteranordnung angesteuert werden, sodass diese nur temporär leuchtet und insbesondere auch nur eine Beleuchtung des zweiten Lichtaustrittsbereichs bereitstellt. Dazu wird das Licht der zweiten Lichtquelle vorzugsweise zumindest zum Großteil und im Wesentlichen parallel zu einer Flächennormalen der zweiten Seite in diesem zweiten Lichteintrittsbereich der Lichtleiterfolie eingekoppelt. Weiterhin kann zwischen der zweiten Lichtquelle und dem zweiten Lichteintrittsbereich ein weiterer Lichtleiter angeordnet sein, wodurch flexiblere Anordnungsmöglichkeiten bezüglich der zweiten Lichtquelle bereitgestellt sind.

Bei einer weiteren vorteilhaften Ausgestaltung der Erfindung unterscheidet sich eine Eigenschaft einer Oberfläche des ersten Lichtaustrittsbereichs der ersten Seite von einer Eigenschaft einer Oberfläche des zweiten Lichtaustrittsbereichs der ersten Seite, insbesondere wobei die erste Seite der Lichtleiterfolie im zweiten Lichtaustrittsbereich keine Aktivierungsstrukturen aufweist. Dadurch kann vorteilhafterweise erreicht werden, dass das im Lichtleiter geführte Licht in diesem zweiten Lichtaustrittsbereich nicht oder kaum austritt, und dieser zweite Lichtaustrittsbereich nur dann leuchtend erscheint, wenn dieser von der zweiten Lichtquelle beleuchtet wird.

Des Weiteren betrifft die Erfindung ein Kraftfahrzeug mit einer erfindungsgemäßen beleuchtbaren Schalteranordnung oder einer ihrer Ausgestaltungen. Die in Bezug auf die erfindungsgemäße beleuchtbare Schalteranordnung und ihre Ausgestaltungen genannten Vorteile gelten in gleicher Weise für das erfindungsgemäße Kraftfahrzeug.

Des Weiteren betrifft die Erfindung ein Verfahren zum Herstellen einer beleuchtbaren Schalteranordnung für ein Kraftfahrzeug. Gemäß dem erfindungsgemäßen Verfahren wird eine transparente Lichtleiterfolie bereitgestellt, welche eine Dicke aufweist, eine erste Seite und eine zweite Seite, wobei die erste Seite und die zweite Seite die Lichtleiterfolie in ihrer Dicke begrenzen und gegenüberliegend und durch die Dicke der Lichtleiterfolie beabstandet angeordnet sind. Dabei sind weiterhin Abmessungen der ersten Seite und der zweiten Seite jeweils größer als die Dicke der Lichtleiterfolie, wobei die Lichtleiterfolie weiterhin eine von der ersten und zweiten Seite verschiedene Lichteintrittsseite aufweist, in welche Licht einkoppelbar ist, und welche die erste Seite und die zweite Seite miteinander verbindet. Des Weiteren wird die erste Seite der Lichtleiterfolie mit einer Beschichtung zur Erhaltung der Lichtleitung beschichtet und weiterhin die Beschichtung zur Erhaltung der Lichtleitung mit einer Farbbeschichtung beschichtet. Darüber hinaus werden die Beschichtung zur Erhaltung der Lichtleitung und die Farbbeschichtung derart ausgebildet, dass eine jeweilige Aussparung in der Beschichtung zur Erhaltung der Lichtleitung und Farbbeschichtung bereitgestellt ist, sodass zumindest ein erster Lichtaustrittsbereich der ersten Seite der Lichtleiterfolie nicht von der Beschichtung zur Erhaltung der Lichtleitung und der Farbbeschichtung bedeckt ist. Weiterhin werden ein Schalterelement und die beschichtete Lichtleiterfolie derart zueinander angeordnet, dass sich das Schalterelement auf der zweiten Seite der Lichtleiterfolie befindet. Das Bilden der Aussparung in der Beschichtung zur Erhaltung der Lichtleitung und der Farbbeschichtung kann beispielsweise dadurch erfolgen, dass die erste Seite der Lichtleiterfolie bei der Beschichtung mit der Beschichtung zur Erhaltung der Lichtleitung und der Farbbeschichtung entsprechend maskiert wird. Alternativ können die Beschichtungen, das heißt die Beschichtung zur Erhaltung der Lichtleitung und die Farbbeschichtung auch ohne Maskierung aufgetragen werden, wobei anschließend die Aussparung durch Entfernen entsprechender Bereiche der Beschichtungen mittels Laserverfahren erfolgt. Diese zweite Variante hat den großen Vorteil, dass beim Entfernen der Beschichtungen gleichzeitig die Aktivierung der ersten Seite im Lichtaustrittsbereich der Lichtleiterfolie durchgeführt werden kann, was eine besonders effiziente und zeitsparende Herstellung der Schalteranordnung ermöglicht.

Die für die erfindungsgemäße Schalteranordnung und ihre Ausgestaltungen genannten Merkmale, Merkmalskombinationen und deren Vorteile gelten in gleicher Weise für das erfindungsgemäße Verfahren zum Herstellen der Schalteranordnung. Darüber hinaus ermöglichen die im Zusammenhang mit der erfindungsgemäßen Schalteranordnung und ihren Ausgestaltungen genannten gegenständlichen Merkmale die Weiterbildung des erfindungsgemäßen Verfahrens durch weitere Verfahrensschritte.

Weitere Vorteile, Merkmale und Einzelheiten der Erfindung ergeben sich aus der nachfolgenden Beschreibung bevorzugter Ausführungsbeispiele sowie anhand der Zeichnung. Dabei zeigen:
- Fig. 1: eine schematische Darstellung einer Schalteranordnung gemäß einem Ausführungsbeispiel der Erfindung; und
- Fig. 2: ein Ablaufdiagramm zur Veranschaulichung eines Verfahrens zur Herstellung einer Schalteranordnung gemäß einem Ausführungsbeispiel der Erfindung.

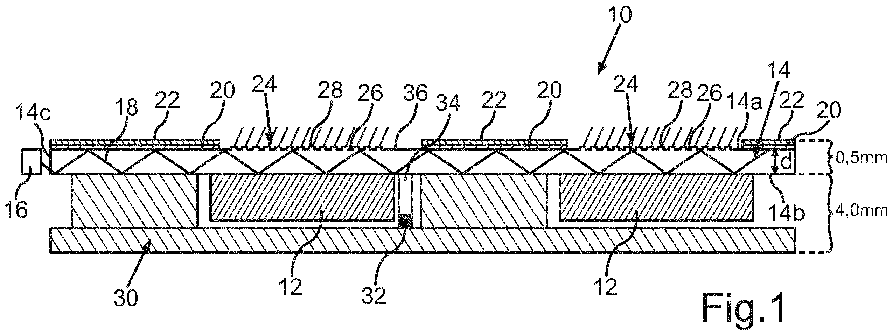

Fig. 1 zeigt eine schematische Querschnittsdarstellung einer Schalteranordnung 10 gemäß einem Ausführungsbeispiel der Erfindung. Die Schalteranordnung 10 ist in diesem Beispiel als eine Schalteinheit mit mehreren Schalterelementen 12, insbesondere kapazitiven oder piezoelektrischen Schalterelementen 12 ausgebildet. Zur Bereitstellung einer Symbolbeleuchtung in Form einer Suchbeleuchtung weist die Schalteranordnung 10 einen 3D-Lichtleiter auf Folienbasis, das heißt eine Lichtleiterfolie 14, auf. Diese Lichtleiterfolie 14 weist eine Dicke d auf, eine erste Seite 14a, eine zweite Seite 14b, die der ersten Seite 14a gegenüberliegend angeordnet ist, und eine Lichteintrittsseite 14c zum Einkoppeln des von einer ersten Lichtquelle 16 bereitgestellten Lichts.

Um eine möglichst geringe Bauhöhe zu erreichen, ist es besonders vorteilhaft, die zu beleuchtende Symbolik oder entsprechende Symbolmasken nicht als separate bauliche Einheiten in einem Abstand zum Lichtleiter anzuordnen, sondern beleuchtbare Symbole, Ornamente oder ähnliches direkt auf der Lichtleiterfolie 14 bereitzustellen. Da jedoch eine Lackierung der Lichtleiterfolie, mit einem farbigen Lack dazu führen würde, dass das im Lichtleiter geführte Licht 18 gestreut und/oder absorbiert werden würde und damit der Lichtleiter seine Funktion verlieren würde, ist nun erfindungsgemäß vorteilhafterweise auf der ersten Seite 14a der Lichtleiterfolie 14 eine Beschichtung 20 zur Erhaltung der Lichtleitung vorgesehen. Diese ist vorzugsweise aus einer transparenten Lackschicht mit geringerem Brechungsindex als die Lichtleiterfolie 14 gebildet. Die Lichtleiterfolie selbst kann zum Beispiel aus PMMA oder PC gebildet sein. Auf diese transparente Beschichtung ist weiterhin eine Farbbeschichtung 22 in Form eines farbigen Dekorlacks aufgebracht, um die Farbanpassung und den notwendig Kontrast für die Symbolik zu erreichen. Um Symbole bereitzustellen, weisen die transparente Beschichtung 20 und die Farbbeschichtung 22 jeweils symbolformende Aussparungen 24 auf, die damit korrespondierende erste Lichtaustrittsbereiche 26 der ersten Seite 14a der Lichtleiterfolie 14 freilegen. Diese Aussparungen 24 können beispielsweise dadurch erzeugt werden, dass die Dekorlackschicht, das heißt die Farbbeschichtung 22, und die transparente Lackschicht, das heißt die Beschichtung 20, im Symbolbereich mittels Laserverfahren entfernt werden. Durch ein solches Laserverfahren können vorteilhafterweise gleichzeitig die den Lichtaustritt aus dem Lichtaustrittsbereich 26 fördernde Aktivierungsstrukturen 28 in der ersten Seite 14a der Lichtleiterfolie 14 erzeugt werden. Damit lassen sich verschiedenste Symbolbeleuchtungen an unterschiedlichen Stellen bereitstellen, die durch die gleiche Lichtquelle 16 über die Lichtleiterfolie 14 mit Licht versorgt werden können.

Durch die transparente Beschichtung 20 lassen sich zudem besonders große Flächen homogen beleuchten. Dies eignet sich besonders für eine Suchbeleuchtung, das heißt eine permanent bereitgestellte Beleuchtung von entsprechenden Schalterelementen 12 zugeordneten Symbolen, um diese beispielsweise auch bei Dunkelheit leicht zu finden. Damit muss vorteilhafterweise nicht für jedes einzelne Schalterelement 12 eine eigene Lichtquelle vorgesehen werden. Die Schalterelemente 12 sind dabei auf der zweiten Seite 14b der Lichtleiterfolie 12 angeordnet, insbesondere auf einem gemeinsamen Träger 30, über welchen auch gleichzeitig die notwendige elektrische Verschaltung vorgenommen werden kann. Durch die variable Anordnung von Symbolen können somit verschiedene Design und Schalteranordnungen innerhalb derselben Trägerbaugruppe generiert werden. Diese Designs können einfach getauscht werden. Dadurch lassen sich zum Beispiel Kundenwünsche, unterschiedliche Varianten oder Produktaufwertungsmaßnahmen innerhalb des gleichen Grundträgers einfach realisieren. Mit anderen Worten kann der Träger 30 mit den darauf angeordneten Schalterelementen 12 für die unterschiedlichsten Designs und Ausgestaltungen genutzt werden. Diese unterschiedlichen Designs können auf besonders einfache Weise durch korrespondierende Beschichtungen der Lichtleiterfolie bereitgestellt werden, zum Beispiel in unterschiedlichen Farben der Farbbeschichtung 24, durch unterschiedliche Ausgestaltung der Symbole, die durch die Aussparungen 24 bereitgestellt werden und so weiter. Auch können beispielsweise unterschiedliche Symbolhelligkeiten durch unterschiedliche Dichten der eingelaserten Aktivierungsstrukturen 28 realisiert werden. Durch eine höhere Strukturdichte der Aktivierungsstruktur 28 lässt sich zum Beispiel eine intensivere Beleuchtung bereitstellen.

Des Weiteren weist in diesem Beispiel die Schalteranordnung 10 noch eine weitere Lichtquelle 32 für eine Funktionsrückmeldung auf. Diese ist, insbesondere zusammen mit einem weiteren Lichtleiter 34, in einem Bereich der zweiten Seite 14b der Lichtleiterfolie 14 angeordnet, welcher in einem zweiten Lichtaustrittsbereich 36 der ersten Seite 14a der Lichtleiterfolie 14 angeordnet ist. Dieser zweite Lichtaustrittsbereich 36 ist dabei ebenfalls nicht von der Farbbeschichtung 22 bedeckt. Je nach Beschichtungsverfahren ist in diesem zweiten Lichtaustrittsbereich 36 auch die transparente Beschichtung 20 entfernt. Wird zum Beispiel die Farbbeschichtung 22 mittels Laserverfahren entfernt wird, so wird dabei gleichzeitig auch die transparente Beschichtung 20 entfernt. In diesem Lichtaustrittsbereich 36 ist zudem auch keine Aktivierung der Lichtleiterfolienoberfläche erforderlich, und insbesondere auch nicht bevorzugt, da durch diesen zweiten Lichtaustrittsbereich 36 vornehmlich das Licht der zweiten Lichtquelle 32, und nicht das durch die Lichtleiterfolie 14 geführt Licht 18 ausgekoppelt werden soll.

Optional kann im zweiten Lichtaustrittbereich 36 die transparente Beschichtung 20 auch vorhanden sein, zum Beispiel wenn die transparente Beschichtung 20 und die Farbbeschichtung 22 mit entsprechender Maskierung auf die Lichtleiterfolie 14 aufgebracht werden, kann dies so bewerkstelligt werden, dass im zweite Lichtaustrittsbereich 36 nur die transparente Beschichtung 20, nicht jedoch die Farbbeschichtung 22 vorhanden ist. Da das Licht dieser zweiten Lichtquelle 32 im Wesentlichen senkrecht in die Lichtleiterfolie 14 eingekoppelt und damit auch ausgestrahlt wird, würde auch das Vorhandensein der transparenten Beschichtung 20 im zweiten Lichtaustrittsbereich 36 den Lichtaustritt nicht mindern.

Die Lichtquelle 32 für die Funktionsrückmeldung kann beispielsweise in Abhängigkeit von einer Betätigungshandlung des Benutzers aktiviert und deaktiviert werden, und nicht wie die erste Lichtquelle 16 eine permanente Beleuchtung bereitstellen. Auch die zweite Lichtquelle kann zum Beispiel eine LED oder eine andere Lichtquelle sein.

Weiterhin ist es auch denkbar, dass die Lichtleiterfolie 14 nicht eben angeordnet ist wie dargestellt, sondern beispielsweise auch gekrümmt, was vielzählige Ausgestaltungsmöglichkeiten bezüglich der bereitzustellenden Bedienoberfläche bereitstellt. Derartige Ausgestaltungen sind durch die flexible Lichtleiterfolie auf einfache Weise möglich.

Die transparente Beschichtung 20 kann alternativ zu einem transparenten Lack auch als transparente Folie mit geringerem Brechungsindex als die Lichtleiterfolie 14 ausgebildet sein. Als Alternative zur Ausbildung der Beschichtung 20 als transparente Beschichtung 20 ist es auch denkbar eine reflektierende Beschichtung vorzusehen. Zudem besteht auch die Möglichkeit, die Aktivierungsstrukturen 28 nicht im ersten Lichtaustrittbereich 26, sondern auf der zweiten Seite 14b der Lichtleiterfolie 14 in einem dem ersten Lichtaustrittsbereich 26 gegenüberliegenden Bereich vorzusehen. Durch diese Varianten in der Ausbildung der Schalteranordnung 10 lassen sich zudem leicht unterschiedliche Leuchteigenschaften bereitstellen, die somit je nach gewünschten zu erzeugenden optischen Eigenschaften der Schalteranordnung 10 realisiert werden können.

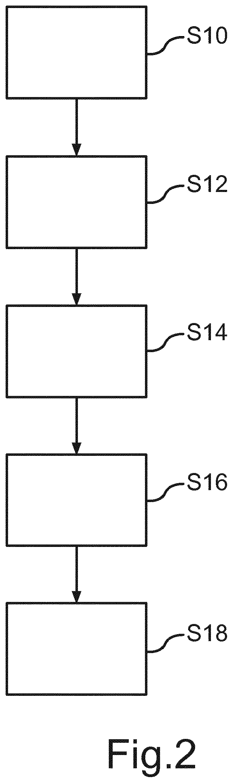

Fig. 2 zeigt ein Ablaufdiagramm zur Veranschaulichung der Herstellung einer Schalteranordnung 10 gemäß einem Ausführungsbeispiel der Erfindung. Hierzu wird zunächst in Schritt S10 die Lichtleiterfolie 14 bereitgestellt, auf welche in Schritt S12 die zur Erhaltung der Lichtleitung Beschichtung 20 in Form einer transparenten Lackschicht mit geringerem Brechungsindex als die Lichtleiterfolie 14 aufgebracht wird. Dazu kann die Lichtleiterfolie 14 auf ihrer ersten Seite 14a mit dieser transparenten Lackschicht 20 lackiert oder bedruckt werden, insbesondere vollflächig. Auf dieser transparenten Beschichtung 20 wird im Schritt S14 weiterhin ein farbiger Dekorlack 22, zum Beispiel ebenfalls durch Lackieren oder Bedrucken, aufgebracht. In Schritt S16 wird die Dekorlackschicht 22 zur Ausbildung eines Symbolbereichs mittels Laserverfahren in vorbestimmten Bereichen entfernt. Damit einhergehend wird auch die darunterliegende transparente Beschichtung 20 in den korrespondierenden Bereichen entfernt, wodurch beleuchtbare Lichtaustrittsbereiche der ersten Seite der Lichtleiterfolie 14 freigelegt werden. Gleichzeitig werden auch in diesen ersten Lichtaustrittsbereichen 26 die notwendigen Strukturen für die Symbolbeleuchtung, das heißt die Aktivierungsstrukturen 28, erzeugt. Optional können auch noch zusätzliche Sichtfenster zur Bereitstellung der zweiten Lichtaustrittsbereiche 36 freigelasert werden, die insbesondere nicht mit Aktivierungsstrukturen 28 versehen werden, um die Funktionsrückmeldungsbeleuchtung bereitstellen zu können. Anschließend kann im Schritt S18 die beschichtete Lichtleiterfolie 14 am Träger 30 mit den darauf angeordneten Schaltelementen 12 angeordnet werden.

Somit können insgesamt innerhalb derselben Fläche beliebige Schalterelemente 12 mit korrespondierender Symbolbeleuchtung neben- oder hintereinander angeordnet werden. Alle Symbolbeleuchtungen können damit vorteilhafterweise durch die gleiche Lichtquelle 14 versorgt werden.

So werden insgesamt eine Schalteranordnung mit einem oder mehreren kapazitiven oder piezoelektrischen Schaltelementen mit korrespondierender Symbolbeleuchtung und ein Verfahren zu deren Herstellung bereitgestellt werden, die eine besonders reduzierte Bauhöhe ermöglichen. Durch Einsatz eines mehrschichtigen Folienaufbaus, das heißt der mehrfach beschichteten Lichtleiterfolie, können die Merkmale Farbanpassung des Schalters und Durchleuchtbarkeit in einem wesentlich geringeren Bauraum generiert werden. Dadurch können Leichtbauschaltelemente wie zum Beispiel freistehende Bedienfelder im Kraftfahrzeug generiert werden. Insbesondere können dadurch Bauhöhen kleiner als 5 Millimeter erreicht werden. Zusätzlich können vielzählige unterschiedliche Ausgestaltungen auf besonders kostengünstige Weise und mit einer äußerst geringen Anzahl an Komponenten erzielt werden.

## Patentansprüche

1. Beleuchtbare Schalteranordnung (10) für ein Kraftfahrzeug, wobei die Schalteranordnung (10) mindestens ein Schalterelement (12) zur Erfassung einer Betätigungshandlung eines Benutzers und eine transparente Lichtleiterfolie (14) aufweist, welche eine Dicke (d) aufweist, eine erste Seite (14a) und eine zweite Seite (14b), wobei die erste Seite (14a) und die zweite Seite (14b) die Lichtleiterfolie (14) in ihrer Dicke (d) begrenzen und gegenüberliegend und durch die Dicke der Lichtleiterfolie (14) beabstandet angeordnet sind, wobei Abmessungen der ersten Seite (14a) und der zweiten Seite (14b) jeweils größer sind als die Dicke (d) der Lichtleiterfolie (14), wobei die Lichtleiterfolie (14) weiterhin eine von der ersten und zweiten Seite (14b) verschiedene Lichteintrittsseite (14c) aufweist, in welche Licht einkoppelbar ist, und welche die erste Seite (14a) und die zweite Seite (14b) miteinander verbindet, wobei das Schalterelement (12) auf der zweiten Seite (14b) der Lichtleiterfolie (14) angeordnet ist,
**dadurch gekennzeichnet, dass**
sich auf der ersten Seite (14a) der Lichtleiterfolie (14) eine Beschichtung (20) zur Erhaltung der Lichtleitung befindet, wobei sich eine Farbbeschichtung (22) auf der Beschichtung (20) zur Erhaltung der Lichtleitung befindet, und wobei die Beschichtung (20) und die Farbbeschichtung (22) jeweils eine Aussparung (24) aufweisen, sodass zumindest ein erster Lichtaustrittsbereich (26) der ersten Seite (14a) der Lichtleiterfolie (14) nicht von der Beschichtung (20) zur Erhaltung der Lichtleitung und der Farbbeschichtung (22) bedeckt ist.

2. Schalteranordnung (10) nach Anspruch 1,
**dadurch gekennzeichnet, dass**
die Beschichtung (20) zur Erhaltung der Lichtleitung als eine reflektierende Beschichtung ausgebildet ist, die dazu ausgelegt ist, durch die Lichtleiterfolie (14) geführtes Licht (18) zu reflektieren, oder als eine transparente Beschichtung (20) ausgebildet ist, die einen niedrigeren Brechungsindex aufweist als die Lichtleiterfolie (14).

3. Schalteranordnung (10) nach einem der vorhergehenden Ansprüche,
**dadurch gekennzeichnet, dass**
die Lichtleiterfolie (14) Aktivierungsstrukturen (28) zur Lichtauskopplung aufweist, insbesondere im ersten Lichtaustrittsbereich (26) der ersten Seite (14a).

4. Schalteranordnung (10) nach einem der vorhergehenden Ansprüche,
**dadurch gekennzeichnet, dass**
die Schalteranordnung (10) zumindest eine erste Lichtquelle (16) aufweist, die dazu ausgelegt ist, die Lichteintrittsseite (14c) der Lichtleiterfolie (14) zu beleuchten.

5. Schalteranordnung (10) nach einem der vorhergehenden Ansprüche,
**dadurch gekennzeichnet, dass**
das Schalterelement (12) in einem Bereich der zweiten Seite (14b) angeordnet ist, welcher dem Lichtaustrittsbereich (26) der ersten Seite (14a) gegenüberliegt.

6. Schalteranordnung (10) nach einem der vorhergehenden Ansprüche,
**dadurch gekennzeichnet, dass**
die Schalteranordnung (10) einen Träger (30) aufweist, auf welchem das Schalterelement (12) anageordnet ist, so dass sich das Schalterelement (12) zwischen dem Träger (30) und der Lichtleiterfolie (14) befindet.

7. Schalteranordnung (10) nach einem der vorhergehenden Ansprüche,
**dadurch gekennzeichnet, dass**
die erste Seite (14a) der Lichtleiterfolie (14) einen zweiten Lichtaustrittsbereich (36) aufweist, der zumindest nicht von der Farbbeschichtung (22), und insbesondere auch nicht von der Beschichtung (20) zur Erhaltung der Lichtleitung bedeckt ist, wobei die zweite Seite (14b) der Lichtleiterfolie (14) einen zum zweiten Lichtaustrittsbereich (36) korrespondierenden, insbesondere dem zweiten Lichtaustrittsbereich (36) gegenüberliegenden, zweiten Lichteintrittsbereich aufweist, wobei die Schalteranordnung (10) eine zweite Lichtquelle (32) aufweist, mittels welcher Licht in den zweiten Lichteintrittsbereich einkoppelbar ist, welches aus dem zweiten Lichtaustrittsbereich (36) austritt.

8. Schalteranordnung (10) nach Anspruch 7,
**dadurch gekennzeichnet, dass**
sich eine Eigenschaft einer Oberfläche des ersten Lichtaustrittsbereichs (26) der ersten Seite (14a) von einer Eigenschaft einer Oberfläche des zweiten Lichtaustrittsbereichs (36) der ersten Seite (14a) unterschiedet, insbesondere wobei die erste Seite (14a) der Lichtleiterfolie (14) im zweiten Lichtaustrittsbereich (36) keine Aktivierungsstrukturen (28) aufweist.

9. Kraftfahrzeug mit einer Schalteranordnung (10) nach einem der Ansprüche 1 bis 8.

10. Verfahren zum Herstellen einer beleuchtbaren Schalteranordnung (10) für ein Kraftfahrzeug, wobei
- eine transparente Lichtleiterfolie (14) bereitgestellt wird, welche eine Dicke aufweist, eine erste Seite (14a) und eine zweite Seite (14b), wobei die erste Seite (14a) und die zweite Seite (14b) die Lichtleiterfolie (14) in ihrer Dicke begrenzen und gegenüberliegend und durch die Dicke der Lichtleiterfolie (14) beabstandet angeordnet sind, wobei Abmessungen der ersten Seite (14a) und der zweiten Seite (14b) jeweils größer sind als die Dicke der Lichtleiterfolie (14), wobei die Lichtleiterfolie (14) weiterhin eine von der ersten und zweiten Seite (14b) verschiedene Lichteintrittsseite aufweist, in welche Licht einkoppelbar ist, und welche die erste Seite (14a) und die zweite Seite (14b) miteinander verbindet;
**dadurch gekennzeichnet, dass**
- die erste Seite (14a) der Lichtleiterfolie (14) mit einer Beschichtung (20) zur Erhaltung der Lichtleitung zur Erhaltung der Lichtleitung beschichtet wird;
- die Beschichtung (20) zur Erhaltung der Lichtleitung mit einer Farbbeschichtung (22) beschichtet wird;
- die Beschichtung zur Erhaltung der Lichtleitung (20) und die Farbbeschichtung (22) derart ausgebildet werden, dass eine jeweilige Aussparung in der Beschichtung (20) zur Erhaltung der Lichtleitung und Farbbeschichtung (22) bereitgestellt ist, sodass zumindest ein erster Lichtaustrittsbereich der ersten Seite (14a) der Lichtleiterfolie (14) nicht von der Beschichtung (20) zur Erhaltung der Lichtleitung und der Farbbeschichtung (22) bedeckt ist; und
- ein Schalterelement (12) und die beschichtete Lichtleiterfolie (14) derart zueinander angeordnet werden, dass sich das Schalterelement (12) auf der zweiten Seite (14b) der Lichtleiterfolie (14) befindet.

## Claims

1. Illuminable switch arrangement (10) for a motor vehicle, wherein the switch arrangement (10) has at least one switch element (12) for detecting an activating action of a user and a transparent light conductor film (14), which has a thickness (d), a first side (14a) and a second side (14b), wherein the first side (14a) and the second side (14b) delimit the light conductor film (14) in its thickness (d) and are arranged opposite and spaced apart by the thickness of the light conductor film (14), wherein dimensions of the first side (14a) and the second side (14b) are greater respectively than the thickness (d) of the light conductor film (14), wherein the light conductor film (14) also has a light inlet side (14c) different from the first and second side (14b), into which light can be coupled, and which connects the first side (14a) and the second side (14b) to one another, wherein the switch element (12) is arranged on the second side (14b) of the light conductor film (14),
**characterised in that**
on the first side (14a) of the light conductor film (14) there is a coating (20) for maintaining the light conduction, wherein there is colour coating (22) on the coating (20) for maintaining the light conduction, and wherein the coating (20) and the colour coating (22) each have a recess (24), so that at least one first light outlet area (26) of the first side (14a) of the light conductor film (14) is not covered by the coating (20) for maintaining the light conduction and the colour coating (22).

2. Switch arrangement (10) according to claim 1,
**characterised in that**
the coating (20) for maintaining the light conduction is designed as a reflective coating, which is designed to reflect light (18) guided through the light conductor film (14), or is designed as a transparent coating (20), which has a lower refractive index than the light conductor film (14).

3. Switch arrangement (10) according to any of the preceding claims,
**characterised in that**
the light conductor film (14) has activating structures (28) for light extraction, in particular in the first light outlet area (26) of the first side (14a).

4. Switch arrangement (10) according to any of the preceding claims,
**characterised in that**
the switch arrangement (10) has at least one first light source (16) which is configured to illuminate the light inlet side (14c) of the light conductor film (14).

5. Switch arrangement (10) according to any of the preceding claims,
**characterised in that**
the switch element (12) is arranged in an area of the second side (14b), which is opposite the light outlet area (26) of the first side (14a).

6. Switch arrangement (10) according to any of the preceding claims,
**characterised in that**
the switch arrangement (10) has a support (30) on which the switch element (12) is arranged so that the switch element (12) is located between the support (30) and the light conductor film (14).

7. Switch arrangement (10) according to any of the preceding claims,
**characterised in that**
the first side (14a) of the light conductor film (14) has a second light outlet area (36) which is at least not covered by the colour coating (22), and in particular is also not covered by the coating (20) for maintaining the light conduction, wherein the second side (14b) of the light conductor film (14) has a second light inlet area corresponding to the second light outlet area (36), in particular opposite the second light outlet area (36), wherein the switch arrangement (10) has a second light source (32), by means of which light can be coupled into the second light inlet area, which exits from the second light outlet area (36).

8. Switch arrangement (10) according to claim 7,
**characterised in that**
a property of a surface of the first light outlet area (26) of the first side (14a) differs from a property of a surface of the second light outlet area (36) of the first side (14a), in particular wherein the first side (14a) of the light conductor film (14) in the second light outlet area (36) has no activation structures (28).

9. Motor vehicle having a switch arrangement (10) according to any of claims 1 to 8.

10. Method for producing an illuminable switch arrangement (10) for a motor vehicle, wherein
- a transparent light conductor film (14) is provided, which has a thickness, a first side (14a) and a second side (14b), wherein the first side (14a) and the second side (14b) delimit the light conductor film (14) in its thickness and are arranged opposite and spaced apart by the thickness of the light conductor film (14), wherein dimensions of the first side (14a) and the second side (14b) are greater respectively than the thickness of the light conductor film (14), wherein the light conductor film (14) also has a light inlet side different from the first and second side (14b), into which light can be coupled, and which connects the first side (14a) and the second side (14b) to one another;
**characterised in that**
- the first side (14a) of the light conductor film (14) is coated with a coating (20) for maintaining the light conduction;
- the coating (20) for maintaining the light conduction is coated with a colour coating (22);
- the coating for maintaining the light conduction (20) and the colour coating (22) are designed such that a respective recess is provided in the coating (20) for maintaining the light conduction and colour coating (22), so that at least one first light outlet area of the first side (14a) of the light conductor film (14) is not covered by the coating (20) for maintaining the light conduction and the second colour coating (22); and
- a switch element (12) and the coated light conductor film (14) are arranged relative to one another such that the switch element (12) is located on the second side (14b) of the light conductor film (14).

## Revendications

1. Ensemble commutateur éclairable (10) pour un véhicule automobile, l'ensemble commutateur (10) présentant au moins un élément de commutation (12) pour détecter un actionnement d'un utilisateur et un film de guidage de lumière transparent (14) ayant une épaisseur (d), un premier côté (14a) et un second côté (14b), le premier côté (14a) et le second côté (14b) délimitant le film de guidage de lumière (14) dans son épaisseur (d) et étant disposés face à face et espacés l'un de l'autre par l'épaisseur du film de guidage de lumière (14), les dimensions du premier côté (14a) et du second côté (14b) étant chacune supérieures à l'épaisseur (d) du film de guidage de lumière (14), le film de guidage de lumière (14) comprenant en outre un côté d'entrée de la lumière (14c) différent du premier et du second côté (14b), la lumière pouvant être couplée et reliant le premier côté (14a) et le second côté (14b) l'un à l'autre, l'élément de commutation (12) étant disposé sur le second côté (14b) du film de guidage de lumière (14),
**caractérisé en ce que**
un revêtement (20) destiné à maintenir le guidage de la lumière se trouve sur le premier côté (14a) du film de guidage de lumière (14), dans lequel un revêtement coloré (22) se trouve sur le revêtement (20) destiné à maintenir le guidage de la lumière, et dans lequel le revêtement (20) et le revêtement coloré (22) présentent chacun un évidement (24), de sorte qu'au moins une première zone de sortie de lumière (26) du premier côté (14a) du film de guidage de lumière (14) n'est pas recouverte par le revêtement (20) destiné à maintenir le guidage de la lumière et le revêtement coloré (22).

2. Ensemble commutateur (10) selon la revendication 1,
**caractérisé en ce que**
le revêtement (20) maintenant le guidage de la lumière est conçu comme un revêtement réfléchissant conçu pour réfléchir la lumière (18) guidée à travers le film de guidage de lumière (14) ou est conçu comme un revêtement transparent (20) présentant un indice de réfraction inférieur au film de guidage de lumière (14).

3. Ensemble commutateur (10) selon l'une quelconque des revendications précédentes,
**caractérisé en ce que**
le film de guidage de lumière (14) présente des structures d'activation (28) pour le découplage de lumière, en particulier dans la première zone de sortie de lumière (26) du premier côté (14a).

4. Ensemble commutateur (10) selon l'une quelconque des revendications précédentes,
**caractérisé en ce que**
l'ensemble commutateur (10) présente au moins une première source de lumière (16) conçue pour éclairer le côté d'entrée de la lumière (14c) du film de guidage de lumière (14).

5. Ensemble commutateur (10) selon l'une quelconque des revendications précédentes,
**caractérisé en ce que**
l'élément de commutation (12) est disposé dans une zone du second côté (14b) qui est opposée à la zone de sortie de lumière (26) du premier côté (14a).

6. Ensemble commutateur (10) selon l'une quelconque des revendications précédentes,
**caractérisé en ce que**
l'ensemble commutateur (10) présente un support (30) sur lequel l'élément de commutation (12) est disposé de sorte que l'élément de commutation (12) se trouve entre le support (30) et le film de guidage de lumière (14).

7. Ensemble commutateur (10) selon l'une quelconque des revendications précédentes,
**caractérisé en ce que**
le premier côté (14a) du film de guidage de lumière (14) présente une seconde zone de sortie de lumière (36) qui est au moins non recouverte par le revêtement coloré (22), et en particulier également non recouverte par le revêtement (20) destiné à maintenir le guidage de la lumière, le second côté (14b) du film de guidage de lumière (14) présentant une surface correspondant à la seconde zone de sortie de lumière (36), en particulier en face de la seconde zone de sortie de lumière (36), l'ensemble commutateur (10) présentant une seconde source de lumière (32) au moyen de laquelle de la lumière peut être couplée dans la seconde zone d'entrée de lumière, qui sort de la seconde zone de sortie de lumière (36).

8. Ensemble commutateur (10) selon la revendication 7,
**caractérisé en ce que**
une propriété d'une surface de la première zone de sortie de lumière (26) du premier côté (14a) diffère d'une propriété d'une surface de la seconde zone de sortie de lumière (36) du premier côté (14a), en particulier dans laquelle le premier côté (14a) du film de guidage de lumière (14) ne présente aucune structure d'activation (28) dans la seconde zone de sortie de lumière (36).

9. Véhicule automobile avec un ensemble commutateur (10) selon l'une quelconque des revendications 1 à 8.

10. Procédé de fabrication d'un ensemble commutateur éclairable (10) pour un véhicule automobile, dans lequel
- un film de guidage de lumière transparent (14) est prévu, qui présente une épaisseur, un premier côté (14a) et un second côté (14b), le premier côté (14a) et le second côté (14b) délimitant le film de guidage de lumière (14) dans son épaisseur et étant disposés face à face et espacés l'un de l'autre par l'épaisseur du film de guidage de lumière (14), les dimensions du premier côté (14a) et du second côté (14b) étant chacune supérieures à l'épaisseur du film de guidage de lumière (14), le film de guidage de lumière (14) comprenant en outre un côté d'entrée de la lumière différent du premier et du second côté (14b), la lumière pouvant être couplée et reliant le premier côté (14a) et le second côté (14b) l'un à l'autre ;
**caractérisé en ce que**
- le premier côté (14a) du film de guidage de lumière (14) est revêtu d'un revêtement (20) destiné à maintenir le guidage de la lumière ;
- le revêtement (20) est revêtu d'un revêtement coloré (22) pour maintenir le guidage de la lumière ;
- le revêtement destiné à maintenir le guidage de la lumière (20) et le revêtement coloré (22) sont conçus de sorte qu'un évidement respectif est prévu dans le revêtement (20) destiné à maintenir le guidage de la lumière et le revêtement coloré (22), de sorte qu'au moins une première zone de sortie de lumière du premier côté (14a) du film de guidage de lumière (14) n'est pas recouverte par le revêtement (20) destiné à maintenir le guidage de la lumière et le revêtement coloré (22) ; et
- un élément de commutation (12) et le film de guidage de lumière revêtu (14) sont disposés l'un par rapport à l'autre de sorte que l'élément de commutation (12) se trouve sur le second côté (14b) du film de guidage de lumière (14).
